# EUROPÄISCHE PATENTSCHRIFT

(11) **EP 0 936 744 B1**
(45) Veröffentlichungstag und Bekanntmachung des Hinweises auf die Patenterteilung: **22.09.2004**
(21) Anmeldenummer: 98102418.5
(22) Anmeldetag: 12.02.1998
(51) Int. Cl.: H04B 1/00, H04N 5/60, H04H 1/00

(54) **Trägererzeugungseinrichtung für einen digitalen Demodulator von MPX-Signalen**
Carrier generating device for a digital demodulator of MPX signals
Dispositif de génération de porteuse pour un démodulateur numérique de signaux MPX

(43) Veröffentlichungstag der Anmeldung: 18.08.1999
(73) Patentinhaber: Micronas GmbH, 79108 Freiburg (DE)
(72) Erfinder: Noeske, Carsten, Dipl.-Ing., 79108 Freiburg (DE); Winterer, Martin, Dipl.-Phys., 79194 Gundelfingen (DE)
(74) Vertreter: Sauer, Wolfgang

(56) Entgegenhaltungen:
- EP-A- 0 305 974
- US-A- 5 023 609
- US-A- 5 357 544
- US-A- 5 467 399
- RAZ Z. AND BORTH D.E.: "A Digital Signal Processing Approach to Multichannel Television Sound Decoding" IEEE TRANSACTIONS ON CONSUMER ELECTRONICS, Bd. 32, Nr. 3, August 1986 (1986-08), Seiten 453-461, XP002071916 NEW YORK, USA

## Beschreibung

MPX-Signale werden bei der Übertragung des frequenzmodulieren Stereo-Rundfunksignals im UKW-Bereich oder bei der Übertragung des Fernsehtons nach dem BTSC-Standard verwendet. Außer der Toninformation kann das MPX-Signal auch Zusatzinformationen enthalten, beispielsweise die ARI-Kennung und/oder die RDS-Information (ARI = Autofahrer Runkfunk Information), RDS = (Radio Data System). Die Frequenzschemata der verschiedenen MPX-Standards unterscheiden sich nur geringfügig voneinander, sie enthalten in Basisbandlage ein Summensignal R+L, oberhalb des Summensignals ein Pilotsignal und bei der zweifachen Pilotfrequenz in Amplitudenmodulation mit unterdrücktem Träger ein Differenzsignal L-R. Ferner können oberhalb des Differenzsignals Zusatzsignale insbesondere im Bereich der dreifachen Pilotfrequenz, vorhanden sein. Der Informationsinhalt der einzelnen Zusatzinformationen ist z.B. mittels einer Einseitenbandmodulation oder insbesondere bei digitalen Informationen mittels einer Quadraturmodulation in das MPX-Signal eingefügt. Die Unterscheidung der einzelnen MPX-Standards ist über die Frequenz des jeweiligen Pilotsignals möglich, die bei Fernsehsignalen nach dem BTSC-Fernsehstandard 15,734 kHz und beim FM-Radio 19 kHz aufweist. Zur Demodulation der einzelnen Signalkomponenten, die über eine Signalmischung erfolgt, sind in dem Demodulator Trägersignale mit der richtigen Frequenz und Phasenlage bereitzustellen, wobei das jeweilige Pilotsignal als Bezugssignal dient. Bei der digitalen Demodulation werden zur Mischung anstatt der analogen Trägersignale digitale Trägersignale verwendet, deren Werte zu den Abtastzeitpunkten den Werten analoger Trägersignale entsprechen. Die im Demodulator gebildeten Trägersignale werden oft auch als Mischungssignale bezeichnet, was jedoch leicht zu einer Verwechslung mit dem Ausgangssignal der Mischung führen kann. Ein Beispiel für einen digitalen Demodulator findet sich in dem Datenblatt: ITT Semiconductors" mit der Bezeichnung CAP 3540B, CAP 3541 B - Car Audio Processor Hardware", Edition 22. Mai 1997, Bestell-Nr. 6251-434-1PD. Der Verarbeitungstakt in der monolithisch integrierten Schaltung ist dabei mit der Frequenz des Pilotsignals verkoppelt.

Ein weiteres Beispiel für einen digitalen Demodulator findet sich in dem Dokument US 5,467,399 ("Coherent Signal Generation in Digital Radio Receiver", 1995-11-14), wo die Trägererzeugungseinrichtung eine Pilotsignal-PLL aufweist, welche zum einen ein dem Pilotsignal zugeordnetes erstes Trägersignal erzeugt und zum anderen ein zweites Trägersignal mit der doppelten Frequenz des ersten Trägersignals erzeugt.

Es ist Aufgabe der Erfindung, einen digitalen Demodulator anzugeben, der unterschiedliche MPX-Standards mit möglichst geringem Zusatzaufwand verarbeitet, wobei die Taktrate des digitalen Trägersignals und damit die Taktrate im digitalen Demodulator von der Frequenz des Pilotsignals unabhängig ist, damit beliebige Taktsysteme verwendbar sind.

Die Lösung der Aufgabe erfolgt durch eine elektronische Umschaltung des Suchbereiches einer einzigen Pilotsignal-PLL entsprechend dem zu empfangenden MPX-Standard und eine systembezogene Phasenkorrektur in der mit der Pilotsignal-PLL verkoppelten Trägererzeugungseinrichtung.

Die Erfindung und vorteilhafte Ausgestaltungen werden nun anhand der Figuren der Zeichnung näher erläutert:
- Fig. 1: zeigt die Hauptstufen eines MPX-Signalempfängers,
- Fig. 2: zeigt als Blockschaltbild ein erstes Ausführungsbeispiel der Erfindung,
- Fig. 3: zeigt zu Fig.2 ein MPX-Frequenz- und Trägerschema,
- Fig. 4: zeigt als Blockschaltbild ein zweites Ausführungsbeispiel,
- Fig. 5: zeigt zu Fig. 4 ein MPX-Frequenz- und Trägerschema,
- Fig. 6: zeigt als Blockschaltbild einen PI-Regler in der Pilotsignal-PLL und
- Fig. 7: zeigt als Blockschaltbild einen vorteilhaften Pilotsignaldetektor.

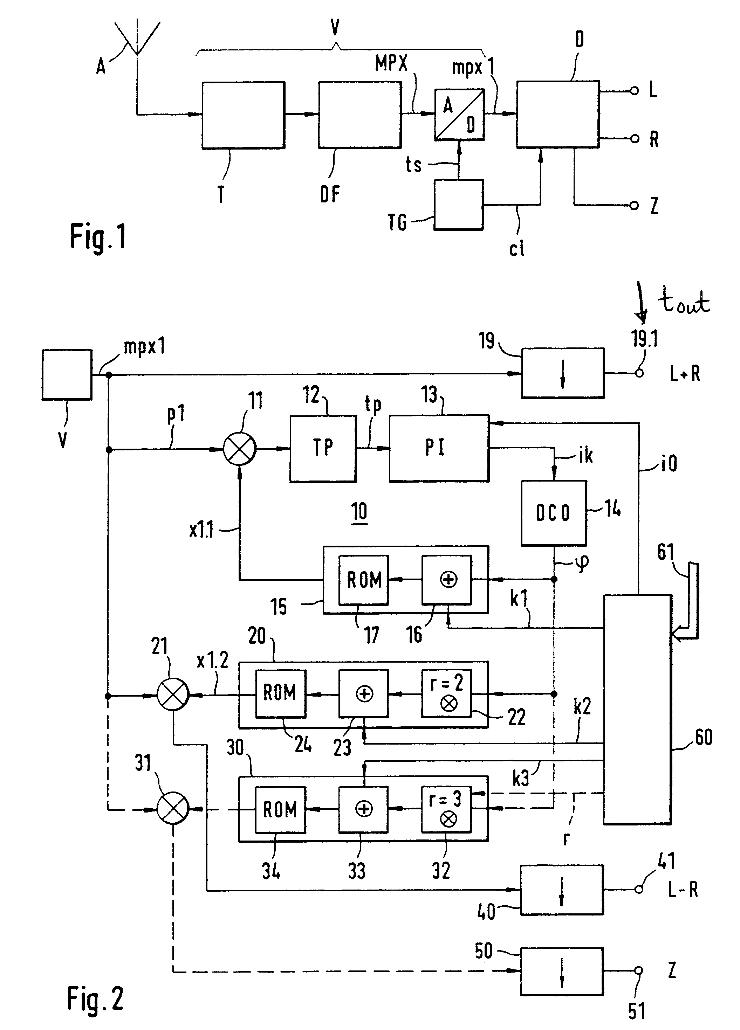

Fig. 1 zeigt die typischen Funktionseinheiten eines digitalen Empfängers für MPX-Signale. Einem digitalen Demodulator D ist ein digitalisiertes MPX-Signal mpx1 zugeführt, das eine vorausgehende Vorstufe V erzeugt, wobei die Datenrate einem Takt t1 entspricht. Die an den digitalen Demodulator D angeschlossenen Schaltungen zur Rechts/ Links-Signaltrennung, Klang- und Verstärkungsregelung sind nicht dargestellt.

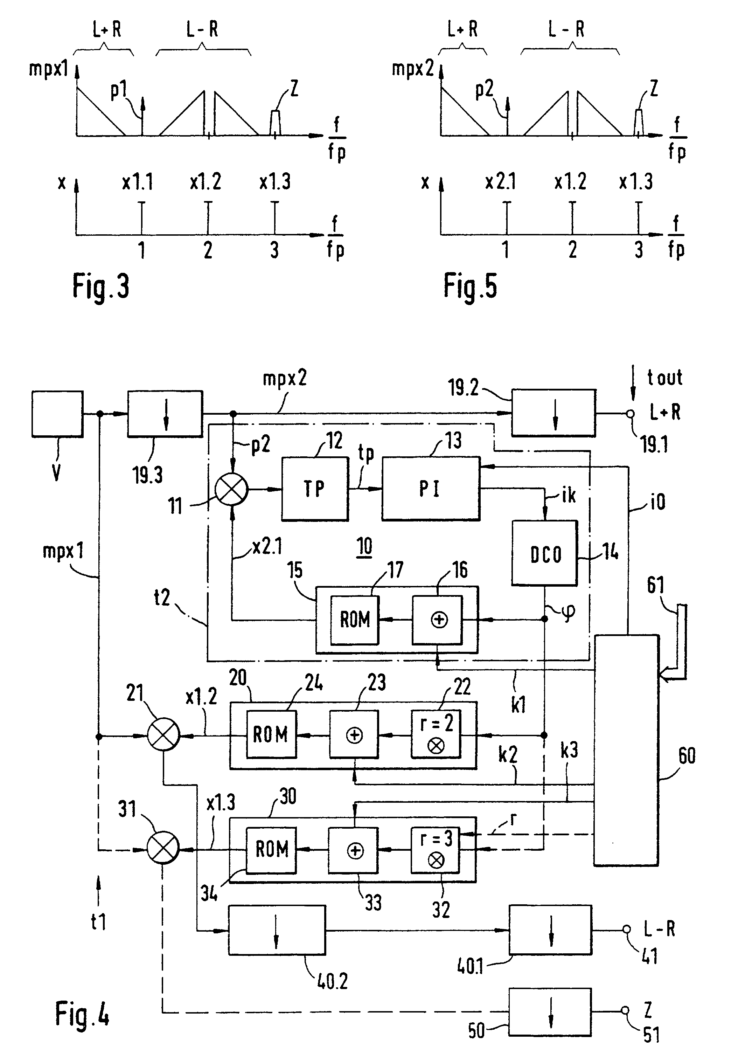

Die Vorstufe V kann Teil eines Radio- oder Fernsehempfängers sein. Der empfangene Radio- oder Fernsehkanal wird mittels einer Antenne A empfangen und einem Tuner T zugeführt, der ihn in eine Zwischenfrequenzlage umsetzt. Das frequenzmodulierte Zwischenfrequenzsignal wird mittels eines FM-Demodulators DF demoduliert und damit befindet sich das MPX-Signal MPX in der Basisbandlage. Ein von einem Digitalisierungstakt ts gesteuerter Analog/Digitalumsetzer AD liefert das digitale MPX-Signal mpx1, dessen weitere Verarbeitung in Fig. 2 und Fig. 4 ausführlich beschrieben wird. Alternativ kann auch ein digitaler FM-Demodulator verwendet werden, dem dann ein bereits digitalisiertes Zwischenfrequenzsignal zugeführt ist. Die Taktrate t1 des digitalisierten MPX-Signals mpx1 ist in der Regel identisch mit dem Digitalisierungstakt ts, der auch als Systemtakt cl im digitalen Demodulators D dient und oder mit ihm verkoppelt ist. Die Takterzeugung ist schematisch mittels eines Taktgenerators TG dargestellt.

Das Ausführungsbeispiel von Fig. 2 zeigt für das digitalisierte MPX-Signal mpx1 eine Trägererzeugungseinrichtung nach der Erfindung. Das von der Vorstufe V mit der Taktrate t1 gelieferte MPX-Signal mpx1 enthält ein Pilotsignal p1, das mittels einer Pilotsignal-PLL 10 herausgefiltert wird. Ein mit dem MPX-Signal mpx1 gespeister Mischer 11 bildet den Eingang der Pilotsignal-PLL. Der Ausgang des Mischers wird mittels eines Tiefpasses 12 gefiltert und einem Regler 13 zugeführt, der eine lineare, nichtlineare oder gemischte Regelkennlinie aufweisen kann. Vorteilhaft erweist sich schon ein einfacher PI-Regler mit der Übertragungsfunktion K(z) = kₚ + kᵢ / (1 + z⁻¹). Der Koeffizient kₚ bestimmt den Proportionalanteil und der Koeffizient kᵢ den Integralanteil. Der Ausgangswert des Reglers 13 dient als Inkrement ik für einen digital gesteuerten Oszillator 14, der als überlaufender Akkumulator ausgebildet ist. Der jeweilige Ausgangswert entspricht einem Phasenwert ϕ, der über eine Winkeltabelle 17 in einem ersten Wertezuordner 15 die Sinus- oder Cosinuswerte des ersten Trägersignals x1.1 bildet, das dem zweiten Eingang des Mischers 11 zugeführt ist. Zur Korrektur der Phasenwerte ϕ enthält der Wertezuordner 15 eine Korrektureinrichtung 16, in der zum jeweiligen Phasenwert ϕ ein konstanter Korrekturwert k1 aus einer Steuereinrichtung 60 mittels einer Modulo-Arithmetik addiert oder subtrahiert wird. Mit dem Korrekturwert k1 werden in der Pilotsignal-PLL 10 systembedingte Phasenabweichungen korrigiert, die beispielsweise durch die Orthogonalität des Trägersignals x1.1 zum Pilotsignal p1, Dezimierungsschaltungen oder Verzögerungseinrichtungen entsteht. Unterschiedliche Pilotsignalfrequen-zen bedingen unterschiedliche Korrekturwerte k1. Durch die Korrektur weist der Ausgangswert ϕ des digital gesteuerten Oszillators 14 zum jeweiligen Pilotsignal p1 eine exakt definierte Phasenbeziehung ohne Offset auf.

Mit der nunmehr bekannten Bezugsphase des Pilotsignals p1 lassen sich das zweite Trägersignal x1.2 für das Differenzsignal L-R und das dritte Trägersignal x1.3 für mindestens ein Zusatzsignal Z bilden. Das Summensignal L+R wird mittels eines ersten Dezimierers 19 mit zugehörigem Tiefpaßfilter direkt aus dem MPX-Signal mpx1 herausgefiltert und ist an einem Anschluß 19.1 abgreifbar.

Das zweite Trägersignal x1.2 zur Umsetzung des Differenzsignals L-R in einem zweiten Mischer 21 wird in einem zweiten Wertezuordner 20 gebildet, der einen mit dem Phasenwert ϕ gespeisten Frequenzvervielfacher 22 mit Modulostufe, eine optionale zweite Korrektureinrichtung 23 und eine Winkeltabelle 24 aufweist. Im Frequenzvervielfacher 22 wird der Phasenwert ϕ mit dem Frequenzvervielfachungswert r = 2 multipliziert wobei durch die Modulostufe der bisherige Wertebereich, der 2π entspricht, festgehalten wird. Die zweite Korrektureinrichtung 23 kann entfallen, wenn die Korrektur schon in der Pilotsignal-PLL 10 erfolgt ist und kein weiterer Phasenfehler auszugleichen ist. Die Reihenfolge der Frequenzvervielfachung und der Korrektur ist vertauschbar, bedarf dann allerdings eines modifizierten Korrekturwertes, da dieser Wert noch mit dem Frequenzvervielfachungswert r multipliziert wird. Das Ausgangssignal des zweiten Mischers 21 enthält das Differenzsignal L-R in Basisbandlage, das mittels eines zweiten Dezimierers 40 mit zugehörigem Tiefpaß herausgefiltert wird, dabei kann der Ausgangstakt tout weiter reduziert werden. Da das an einem Ausgang 41 abgegriffene Differenzsignal L-R in einer nicht dargestellten Matrix mit dem Summensignal L+R kombiniert wird, müssen der Dezimierer 19 und der Dezimierer 40 in den Filtereigenschaften einander gleich sein.

Wenn in dem MPX-Signal mpx1 ein oder mehrere Zusatzsignale enthalten sind, dann ist die zugehörige Trägerfrequenz in der Regel an das Pilotsignal p1 gekoppelt. Zur Gewinnung des oder der Zusatzsignale dient ein dritter Wertezuordner 30, der für einen dritten Mischer 31 ein drittes Trägersignal x1.3 bildet. Der dritte Wertezuordner enthält im Eingang einen Frequenzvervielfacher 32 mit Modulostufe. Der Frequenzvervielfachungswert r hat beispielsweise den Wert drei, wenn die Zusatzinformation mit der dreifachen Pilotsignalfrequenz verknüpft ist. Wenn der Frequenzvervielfachungswert r von der Steuereinrichtung 60 für den jeweiligen MPX-Standard vorgegeben wird, dann können beliebige Zusatzinformationen Z ausgewählt werden. Eine entsprechende Programmierung der Steuereinrichtung 60 erfolgt beispielsweise über einen angedeuteten Bus 61. Der dritte Wertezuordner 30 enthält ferner eine optionale Korrektureinrichtung 33 zur Korrektur der Phase und eine Wertetabelle 34 mit der die jeweiligen Sinus- oder Cosinus-Werte dem Phasenwert ϕ zugeordnet werden. Die Winkeltabellen 17, 24, 34 für die drei Wertezuordner 15, 20, 30 sind beispielsweise als ein Nur-Lesespeicher (=ROM) realisiert. Das Ausgangssignal des dritten Mischers 31 ist das Zusatzsignal Z in Basisbandlage, das mittels eines dritten Dezimierers 50 mit zugehörigem Tiefpaßfilter herausgefiltert wird und an einer Klemme 51 zur Verfügung steht.

Die Zusatzinformation Z bei der dritten Pilotsignalfrequenz enthält bezüglich der Phase des orthogonal modulierten Trägers unterschiedliche Informationen, nämlich die ARI-Kennung und/oder das digitale RDS-Signal. Mittels der dritten Korrektureinrichtung 33 oder einer Umschaltung von Sinus- auf Cosinus-Werte in der dritten Winkeltabelle 34 wird diese mit der entsprechenden Phasenlage in die Basisbandlage transformiert. Diese Umschaltung erfolgt im einfachsten Fall über das dritte Korrektursignal k3 aus der Steuereinrichtung 60.

Die Beschreibung des Ausführungsbeispiels von Fig. 2 zeigt, daß die gewünschte Umschaltung von Fernsehton auf Radioton lediglich durch einfache Steuersignale aus der Steuereinrichtung 60 erfolgt.

Fig. 3 zeigt das Frequenzschema des MPX-Signals mpx1, das mit einem Taktsignal t1 abgetastet ist, dessen Frequenz in einem großen Frequenzbereich zwischen 100 kHz bis hinauf zu einigen MHz liegen kann. Das als Linie dargestellte Pilotsignal p1 definiert die Frequenz und Phasenlage für den Träger des Differenzsignals L-R und den Träger des oder der Zusatzsignale Z. Das zugehörige Trägerschema x im digitalen Demodulator D, das der Taktrate t1 zugeordnet ist, ist darunter gezeichnet und enthält den ersten Träger x1.1 für das Pilotsignal, den zweiten Träger x1.2 für das Differenzsignal L-R und den dritten Träger x1.3 für das Zusatzsignal Z.

Das Ausführungsbeispiel von Fig. 2 erzeugt die Trägersignale x mit der Taktrate t1. Da die Pilotsignal-PLL 10 nur auf das 15 kHz oder 19 kHz aufweisende Pilotsignal p1 einrasten muß, ist eine Reduktion des Verarbeitungstaktes in diesem Funktionsbereich sinnvoll. Die Verwendung von Dezimiereinrichtungen mit zugehörigen Filtern bedingt jedoch eine weitere Verzögerung der zu verarbeitenden Signale in der Pilotsignal-PLL. Diese kann bei der geforderten exakten Phasenbeziehung für die Trägersignale nicht vernachlässigt werden. Durch die vorbestimmten Korrekturwerte k1, k2, k3 können zu den taktbedingten Verzögerungen auch die systembedingten Gruppenlaufzeiten miterfaßt werden.

Fig. 4 zeigt ein Ausführungsbeispiel der Erfindung, bei dem die Trägererzeugungseinrichung möglicht weitgehend von Dezimierungseinrichtungen Gebrauch macht. Die große Ähnlichkeit der Schaltungen von Fig. 2 und Fig. 4 ist sofort erkennbar. Da gleiche Funktionseinheiten wie üblich mit den gleichen Bezugszeichen versehen sind, erübrigt sich eine Wiederholung der grundsätzlichen Beschreibung.

Das Ausführungsbeispiel von Fig. 4 zeigt die Vorstufe V, die das digitale MPX-Signal mpx1 wieder mit der Taktfrequenz t1 liefert. Für die Signalverarbeitung in der Pilotsignal-PLL 10 kann wie erwähnt die Taktrate erheblich reduziert werden. Eine erste Dezimierungseinrichtung 19.3 reduziert die Taktrate t1 des MPX-Signals mpx1 auf eine niedrigere Taktrate t2 und bildet ein dezimiertes MPX-Signal mpx2. Der ganze Bereich in der Trägererzeugungseinrichtung, der mit der niedrigen Taktrate t2 läuft, ist in Fig. 4 mittels einer strichpunktierten Linie eingegrenzt. Die Reduktion der Taktrate hat auf die Frequenz des digital gesteuerten Oszillators 14 und den Phasenwert ϕ außer dem gröberen Zeitraster keinen Einfluß. Trotzdem kann aus dem Phasenwert ϕ nicht ohne weiteres das zweite und dritte Trägersignal x1.2, x1.3 gebildet werden, weil der Phasenwert ϕ auf den Ausgang des Dezimierers 19.3, das erste und zweite Trägersignal x1.2, x1.3 jedoch auf den Eingang des Dezimierers 19.3 bezogen sind. Die schaltungsmäßige Signalverzögerung im Dezimierer 19.3 und die Gruppenlaufzeit seines Filters führt dazu, daß eine zusätzliche Phasenabweichung entsteht. Diese zusätzliche Phasenabweichung kann jedoch ebenfalls mittels des ersten Korrekturwertes k1 ausgeglichen werden, so daß sich der Phasenwert ϕ wieder auf das MPX-Signal mpx1 mit der Taktrate t1 bezieht.

Die Taktrate tout des Summensignals L+R am Ausgang 19.1 erfolgt durch Dezimierung und Filterung des MPX-Signals mpx2 im Dezimierer 19.2. Die beiden Dezimierer 19.3 und 19.2 entsprechen zusammen dem Dezimierer 19 von Fig. 2.

Der zweite und dritte Wertezuordner 20, 30 von Fig. 4 sind identisch zu den entsprechenden Wertezuordnern von Fig. 2. Dies gilt auch für den zweiten und dritten Korrekturwert k1, k2, da der Phasenwert ϕ durch den ersten Korrekturwert k1 auf das MPX-Signal mpx1 vor dem Dezimierer 19.3 bezogen wird. Damit das am Ausgang 41 abgegriffene Differenzsignal L-R, das dem Ausgangstakt tₒᵤₜ zugeordnet ist, die gleiche Phasenbeziehung wie das Summensignal L+R aufweist, muß die zugehörige Dezimierungseinrichtung 40.1, 40.2 die gleichen Eigenschaften wie die beiden Dezimierer 19.3, 19.2 für das Summensignal aufweisen. Das Ausgangssignal des zweiten Mischers 21 ist daher zwei in Reihe geschalteten Dezimierern 40.2, 40.1 zugeführt, die identisch zu den entsprechenden Dezimierern 19.3, 19.2 für das Summensignal L+R sind. Der Dezimierer 50 für das Zusatzsignal Z am Ausgang 51 kann unabhängig zu den anderen Dezimierern sein, weil das Zuatzsignal Z separat verarbeitet wird. Da dessen Signalinhalt nur einen sehr geringen Frequenzbereich umfaßt, kann der Dezimierungsfaktor des Dezimierers 50 im Vergleich zu den anderen Dezimierern höher sein.

Die Reduktion der Taktrate reduziert den Aufwand für Filtereinrichtungen. Daneben ermöglicht die niedere Taktrate aber auch, daß einzelne Funktionseinheiten im Multiplexbetrieb laufen können oder daß zumindest Teilfunktionen durch entsprechend programmierte Prozessoren mitübernommen werden, die infolge ihrer hohen Verarbeitungsgeschwindigkeit die einzelnen Teilfunktionen im Hintergrund nacheinander berechnen, weil das niedere Taktraster hierfür genügend Rechenzeit zur Verfügung stellt.

Fig. 5 zeigt das Frequenzschema des dezimierten MPX-Signals mpx2, dessen Taktrate durch den zweiten Takt t2 bestimmt ist, die Frequenzlagen der einzelnen Signalbereiche jedoch zum MPX-Signal mpx1 identisch sind. Das zugehörige Trägerschema x im digitalen Demodulator D unterscheidet sich gegenüber dem von Fig. 3 dadurch, daß der erste Träger x2.1 dem niederen Takt t2 zugeordnet ist. Die beiden anderen Träger x1.2, x1.3 sind dem hohen ersten Takt t1 zugeordnet.

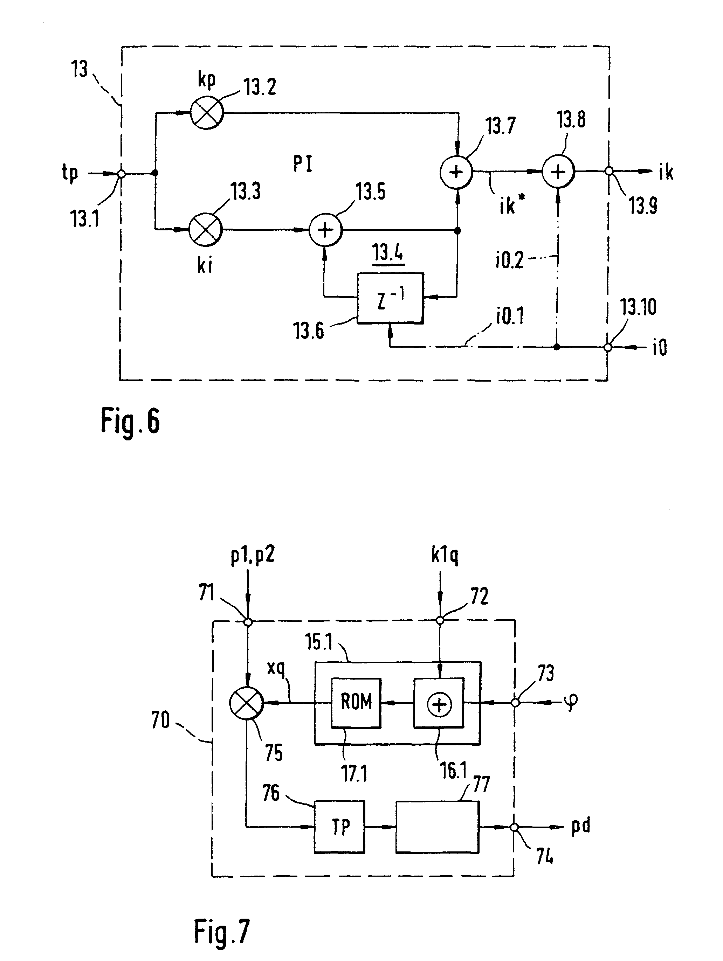

In Fig. 6 ist der Regler 13 als ein PI-Regler etwas ausführlicher dargestellt. Einer Eingangsklemme 13.1 sind die Ausgangswerte tp des Pilotsignal-Tiefpasses 12 zugeführt. Die Verarbeitung spaltet sich danach in einen Proportionalzweig und einen Integralzweig - mit einem Multiplizierer 13.2 bzw. mit einem Multiplizierer 13.3 und einem Akkumulator 13.4 - auf. Beide Zweige werden über einen Addierer 13.7 zusammengeführt und bilden am Ausgang 13.9 einen Inkrementwert ik zur Ansteuerung des digital gesteuerten Oszillators 14. Mittels der Koeffizienten kₚ, kᵢ werden die jeweiligen Proportional- bzw. Integralanteile im PI-Regler 13 bestimmt. Der am Anschluß 13.10 zugeführte Startwert i0 gibt entweder den Startinhalt i0.1 des Akkumulators 13.4 vor oder wird als Startwert i0.2 dem Ausgangswert ik* des Addierers 13.7 mittels eines zweiten Addierers 13.8 hinzugefügt. Der Akkumulator 13.4 besteht wie üblich aus einem Addierer 13.5 und einer Speichereinrichtung 13.6.

Durch die Vorgabe des Startwertes i0 im Regler 13 wird der Inkrementwert ik am Ausgang 13.9 in die Nähe seines Sollwertes gebracht, so daß die Pilotsignal-PLL 10 auf das vorhandene Pilotsignal p1, p2 sicher einrastet und nicht auf ein anderes Signal.

Damit der digitale Demodulator D auch MPX-Signale mpx1, mpx2 verarbeitet, die ein Mono-Signal jedoch kein Pilot- und kein Differenzsignal enthalten, ist ein Pilotsignaldetektor zweckmäßig. Er schaltet im digitalen Demodulator D die Stereosignalverarbeitung ab, wenn kein Pilotsignal vorhanden ist. Auf diese Art wird verhindert, daß die Pilotsignal-PLL auf zufällige Signale oder gar Rauschen einrastet.

In Fig. 7 ist ein Ausführungsbeispiel für einen Pilotsignaldetektor 70 dargestellt, der sich besonders vorteilhaft mit der Trägererzeugungseinrichtung von Fig. 2 oder Fig. 4 kombinieren läßt. Am Eingang 71 wird das jeweilige MPX-Signal mpx1, mpx2 mit dem zugehörigen Pilotsignal p1, p2, am Eingang 72 ein Korrekturwert k1q und am Eingang 73 der Phasenwert ϕ zugeführt - am Ausgang 74 ist das gewünschte Pilot-Detektorsignal pd abgreifbar. Der Pilotsignaldetektor 70 enthält einen Wertezuordner 15.1, der identisch zum ersten Wertezuordner 15 in der Pilotsignal-PLL 10 ist und wie dieser eine Korrektureinrichtung 16.1 und eine Winkeltabelle 17.1 enthält. Der Ausgang des Wertezuordners 15.1 liefert ein Trägersignal xq, das um +/-90 Grad gegenüber dem ersten Trägersignal x1.1 bzw. x2.1 in der Phase gedreht ist. Dieses Trägersignal xq ist dem einen Eingang eines Mischers 75 zugeführt, dessen anderer Eingang mit dem MPX-Signal mpx1 bzw. mpx2 gespeist ist. Die richtige Phasenlage des Trägersignals xq wird mittels des der Korrektureinrichtung 16.1 zugeführten Korrektursignals k1q eingestellt. Der Korrekturwert k1q wird mittels einer Modulo-Arithmetik zum jeweiligen Phasenwert ϕ addiert oder davon subtrahiert.

Im Mischer 75 wird somit beim Vorhandensein eines Pilotsignals p1, p2 eine Multiplikation frequenz- und phasengleicher Signale durchgeführt, nämlich die Multiplikation des Pilotsignals p1 bzw. p2 mit dem Trägersignal xq. Bei vorhandenem Pilotsignal p1, p2 liefert das Ausgangssignal des Mischers 75 einen positiven Mittelwert, der mittels eines Tiefpaßfilters 76 herausgefiltert und danach einer Bewertungseinrichtung 77 zugeführt wird, die beispielsweise einen Schwellwertdetektor enthält. Das Ausgangssignal der Bewertungseinrichtung 77 ist das gewünschte Pilot-Detektorsignal pd. Die Schwellwertentscheidung in der Bewertungsschaltung 77 kann auch durch eine Gewichtung ersetzt werden, wenn zur Bildung des Pilot-Detektorsignals pd komplexere Entscheidungskriterien verwendet werden.

## Patentansprüche

1. Trägererzeugungseinrichtung für einen digitalen Demodulator (D) von digitalen MPX-Signalen (mpx1) mit zugehörigem Pilotsignal (p1), die an einer Vorstufe (V) abgreifbar, mit einem beliebigen Takt (t1) verkoppelt und gegebenenfalls unterschiedlichen Standards zugeordnet sind, mit
- einer Pilotsignal-PLL (10), die auf das jeweilige Pilotsignal (p1) eingerastet ist und in der ein erster Wertezuordner (15) ein dem Pilotsignal (p1) zugeordnetes erstes Trägersignal (x1.1) erzeugt,
- einem zweiten Wertezuordner (20), der mit der Pilotsignal-PLL (10) gekoppelt ist und ein zweites Trägersignal (x1.2) mit der doppelten Frequenz des ersten Trägersignals (x1.1) erzeugt,
**dadurch gekennzeichnet, daß**
- die beiden Wertezuordner jeweils eine Korrektureinrichtung (16, 23) aufweisen, und die Trägererzeugungseinrichtung weiterhin eine Steuereinrichtung (60) aufweist, die entsprechend dem Standard des MPX-Signals (mpx1) einen Startwert (i0) und einen ersten und/oder zweiten Korrekturwert (k1, k2) bereitstellt, wobei der Startwert (i0) den Suchbereich der Pilotsignal-PLL (10) für das Pilotsignal (p1) einstellt und der erste und/oder zweite Korrekturwert (k1, k2) in der ersten und/oder zweiten Korrektureinrichtung (16, 23) die systembedingte Phasenabweichung des ersten und/oder zweiten Trägersignals (x1.2) korrigiert.

2. Trägererzeugungseinrichtung für einen digitalen Demodulator (D) von digitalen MPX-Signalen (mpx1) mit zugehörigem Pilotsignal (p1), die an einer Vorstufe (V) abgreifbar, mit einem beliebigen Takt (t1) verkoppelt und gegebenenfalls unterschiedlichen Standards zugeordnet sind,
**dadurch gekennzeichnet, daß** die Trägererzeugungseinrichtung
- eine Dezimierungseinrichtung (19.3) aufweist, die aus dem MPX-Signal (mp×1) ein dezimiertes MPX-Signal (mpx2) erzeugt, das ein dezimiertes Pilotsignal (p2) enthält und dessen Taktrate einem zweiten Takt (t2) entspricht,
- eine Pilotsignal-PLL (10) aufweist, die auf das jeweilige dezimierte Pilotsignal (p2) eingerastet ist und in der ein erster Wertezuordner (15) ein dem dezimierten Pilotsignal (p2) zugeordnetes dezimiertes erstes Trägersignal (x2.1) erzeugt,
wobei der erste Wertezuordner eine erste Korrektureinrichtung (16) aufweist,
- einen zweiten Wertezuordner (20) aufweist, wobei der erste Wertezuordner eine erste Korrektueinrichtung (16) aufweist, der mit der Pilotsignal-PLL (10) gekoppelt ist und ein zweites Trägersignal (x1.2) mit der doppelten Frequenz des dezimierten ersten Trägersignals (x2.1) erzeugt, wobei der zweite Wertezuordner eine zweite Korrektureinrichtung (23) aufweist, und
- eine Steuereinrichtung (60) aufweist, die entsprechend dem Standard des MPX- Signals (mpx1) einen Startwert (i0) und einen ersten und/oder zweiten Korrekturwert (k1, k2) bereitstellt, wobei der Startwert (i0) den Suchbereich der Pilotsignal-PLL (10) für das dezimierte Pilotsignal (p2) einstellt und der erste und/oder zweite Korrekturwert (k1, k2) in der ersten und/oder zweiten Korrektureinrichtung (16, 23) die systembedingte Phasenabweichung des dezimierten ersten und/oder zweiten Trägersignals (x2.1, x1.2) korrigiert.

3. Trägererzeugungseinrichtung nach einem der Ansprüche 1 oder 2, **dadurch gekennzeichnet, daß** ein dritter Wertezuordner (30) mit der Pilotsignal-PLL (10) gekoppelt ist und ein drittes Trägersignal (x1.3) erzeugt, dessen Frequenz mittels eines Frequenzvervielfachers (32) entweder auf ein vorgegebenes, insbesondere ganzzahliges, Frequenzverhältnis zur Frequenz des Pilotsignals (p1) fest eingestellt oder mittels eines aus der Steuereinrichtung (60) zugeführten Frequenzvervielfachungswertes ( r) beliebig einstellbar ist.

4. Trägererzeugungseinrichtung nach Anspruch 3, **dadurch gekennzeichnet, daß** eine dritte Korrektureinrichtung (33) im dritten Wertezuordner (30) die systembedingte Phasenabweichung des dritten Trägersignals (x1.3) korrigiert und/oder eine definierte Phasenlage einstellt, wozu der dritten Korrektureinrichtung (30) aus der Steuereinrichtung (60) ein dritter Korrekturwert (k3) zugeführt ist.

5. Trägererzeugungseinrichtung nach einem der Ansprüche 1 bis 4, **dadurch gekennzeichnet, daß** die erste, zweite und/oder dritte Korrektureinrichtung (16, 23, 33) zur jeweiligen Korrektur des Phasenwertes ϕ einen Addierer oder Subtrahierer mit Modulo-Arithmetik enthält.

6. Trägererzeugungseinrichtung nach einem der Ansprüche 1 bis 5, **dadurch gekennzeichnet, daß** zur Erzeugung eines Inkrementwertes (ik) für einen digital gesteuerten Oszillator (14) der Startwert (i0) einem in der Pilostsignal-PLL (10) enthaltener Regler (13) zugeführt ist und dort entweder als Startinhalt (i0.1) für einen Akkumulator (13.4) dient oder als bleibender Wert (i0.2) zum Reglerausgangswert (ik*) addiert bzw. von ihm subtrahiert wird und damit den Inkrementwert (ik) bildet.

7. Trägererzeugungseinrichtung nach einem der Ansprüche 1 bis 6, **gekennzeichnet durch** folgende Merkmale:
- die Trägererzeugungseinrichtung enthält einen Pilotsignaldetektor (70) mit
- einem Multiplizierer (75), dessen erster Eingang mit dem MPX-Signal (mpx1, mpx2) und dessen zweiter Eingang mit einem gegenüber dem ersten Trägersignal (x1.1; x2.1) um +/-90 Grad gedrehten Trägersignal (xq) gespeist ist, das mittels eines zum ersten Wertezuordner (15) gleichen weiteren ersten Wertezuordners (15.1) und eines modifizierten ersten Korrekturwertes (k1q) gebildet ist,
- einem Tiefpass (76), der an den Ausgang des Multiplizierers (75) angeschlossen ist, und
- einer dem Tiefpass (76) nachgeschalteten Bewertungseinrichtung (77), an deren Ausgang ein Pilot-Detektorsignal (pd) abgreifbar ist.

## Claims

1. A carrier generation facility for a digital demodulator (D) of digital MPX signals (mpx1) with associated pilot signal (p1) which are provided by a front end (V), are locked to an arbitrary clock signal (t1), and may be assigned to different standards, said carrier generation facility comprising:
- a pilot signal PLL (10) which is in lock with the respective pilot signal (p1) and in which a first value allocator (15) generates a first carrier signal (x1.1), which is assigned to the pilot signal (p1), and
- a second value allocator (20), coupled to the pilot signal PLL (10) and generating a second carrier signal (x1.2), which has twice the frequency of the first carrier signal (x1.1),
**characterized in**
- **that** each of the two value allocators comprises a correcting device (16, 23), and
- **that** the carrier generation facility further comprises a control device (60) which, according to the standard of the MPX signal (mpx1), provides a start value (i0) and a first correction value (k1) and/or a second correction value (k2), with the start value (i0) adjusting the capture range of the pilot signal PLL (10) for the pilot signal (p1), and the first correction value (k1) and/or the second correction value (k2) correcting, in the first correcting device (16) and/or the second correcting device (23), the system-inherent phase deviation of the first and/or second carrier signals (x1.1, x1.2).

2. A carrier generation facility for a digital demodulator (D) of digital MPX signals (mpx1) with associated pilot signal (p1) which are provided by a front end (V), are locked to an arbitrary clock signal (t1), and may be assigned to different standards,
**characterized in that** the carrier signal generation facility comprises:
- a decimator (19.3) for generating from the MPX signal (mpx1) a decimated MPX signal (mpx2) which contains a decimated pilot signal (p2) and whose clock rate is equal to that of a second clock signal (t2);
- a pilot signal PLL (10) which is in lock with the respective decimated pilot signal (p2) and in which a first value allocator (15), comprising a first correcting device (16), generates a decimated first carrier signal (x2.1), which is assigned to the decimated pilot signal (p2);
- a second value allocator (20), comprising a second correcting device (23), is coupled to the pilot signal PLL (10) and generates a second carrier signal (x1.2), which has twice the frequency of the decimated first carrier signal (x2.1); and
- a control device (60) which, according to the standard of the MPX signal (mpx1), provides a start value (i0) and a first correction value (k1) and/or a second correction value (k2), with the start value (i0) adjusting the capture range of the pilot signal PLL (10) for the decimated pilot signal (p2), and the first correction value (k1) and/or the second correction value (k2) correcting, in the first correcting device (16) and/or the second correcting device (23), the system-inherent phase deviation of the decimated first carrier signal (x2.1) and/or of the second carrier signal (x1.2).

3. A carrier generation facility as claimed in claim 1 or 2, **characterized in that** a third value allocator (30) is coupled to the pilot signal PLL (10) and generates a third carrier signal (x1.3) whose frequency is either preset to a predetermined, preferably integral, ratio to the frequency of the pilot signal (p1) by means of a frequency multiplier (32) or arbitrarily settable by means of a frequency multiplication value (r) from the control device (60).

4. A carrier generation facility as claimed in claim 3, **characterized in that** a third correcting device (33) in the third value allocator (30) corrects the system-inherent phase deviation of the third carrier signal (x1.3) and/or sets a defined phase, for which it is fed a third correction value (k3) from the control device (60).

5. A carrier generation facility as claimed in any one of claims 1 to 4, **characterized in that** for the respective correction of the phase value (ϕ), the first, second, and/or third correcting devices (16, 23, 33) contain an adder or subtractor using modulo arithmetic.

6. A carrier generation facility as claimed in any one of claims 1 to 5, **characterized in that** for the generation of an increment value (ik) for a digitally controlled oscillator (14), the start value (i0) is fed to a controller (13) incorporated in the pilot signal PLL (10), and either serves there as a start content (i0.1) for an accumulator (13.4) or is added as a permanent value (i0.2) to, or subtracted as a permanent value (i0.2) from, the controller output value (ik*) to form the increment value.

7. A carrier generation facility as claimed in any one of claims 1 to 6, **characterized by** the following features:
- The carrier generation facility includes a pilot signal detector (70) comprising:
- a multiplier (75) whose first input is presented with the MPX signal (mpx1, mpx2) and whose second input is presented with a carrier signal (xq) shifted in phase by +/-90 degrees with respect to the first carrier signal (x1.1; x2.1), said carrier signal (xq) being formed by means of a further first value allocator (15.1) and a modified first correction value (k1q), said further first value allocator (15.1) being identical to the first value allocator (15);
- a low-pass filter (76) connected to the output of the multiplier (75); and
- an evaluating device (77) following the low-pass filter (76) and providing a pilot detector signal (pd) at its output.

## Revendications

1. Dispositif de génération de porteuse pour un démodulateur numérique (D) de signaux numériques MPX (mxp1) qui comportent un signal pilote (p1) correspondant, qui sont couplés, en pouvant être saisis sur un étage préliminaire (V), à une cadence (t1) arbitraire et qui, le cas échéant, sont associés à des standards différents, ledit dispositif comportant :
- un circuit à boucle à verrouillage de phase (PLL) de signal pilote (10) qui est verrouillé sur le signal pilote (p1) respectif et dans lequel un premier allocateur de valeurs (15) produit un premier signal de porteuse (x1.1) qui est associé au signal pilote (p1),
- un deuxième allocateur de valeurs (20) qui est couplé avec le circuit à boucle à verrouillage de phase (PLL) de signal pilote (10) et produit un deuxième signal de porteuse (x1.2) dont la fréquence est le double de celle du premier signal de porteuse (x1.1),
**caractérisé en ce que** :
- les deux allocateurs de valeurs (15, 20) comportent chacun un dispositif de correction (16, 23) et **en ce que** le dispositif de génération de porteuse comporte en outre un dispositif de commande (60) qui fournit, en correspondance avec le standard du signal MPX (mxp1), une valeur initiale (i0) et une première et/ou une deuxième valeurs de correction (k1, k2), la valeur initiale (i0) réglant le domaine de recherche du circuit à boucle à verrouillage de phase (PLL) de signal pilote (10) pour le signal pilote (p1) et la première et/ou la deuxième valeurs de correction (k1, k2) corrigeant, dans le premier et/ou le deuxième dispositifs de correction (16, 23), la déviation de phase créée par le système du premier et/ou du deuxième signaux de porteuse (x1.1, x1.2).

2. Dispositif de génération de porteuse pour un démodulateur numérique (D) de signaux numériques MPX (mxp1) qui comportent un signal pilote (p1) correspondant, qui sont couplés, en pouvant être saisis sur un étage préliminaire (V), à une cadence (t1) arbitraire et qui, le cas échéant, sont associés à des standards différents,
**caractérisé en ce que** le dispositif de génération de porteuse :
- comporte un dispositif de décimation (19.3) qui produit, à partir du signal MPX (mxp1), un signal MPX (mxp2) ayant subi une décimation qui contient un signal pilote (p2) ayant subi une décimation et dont la fréquence de cadencement correspond à un deuxième cadencement (t2),
- comporte un circuit à boucle à verrouillage de phase (PLL) de signal pilote (10) qui est verrouillé sur le signal pilote (p2) ayant subi une décimation respectif et dans lequel un premier allocateur de valeurs (15) produit un premier signal de porteuse (x2.1) associé ayant subi une décimation qui est associé au signal pilote (p2) ayant subi une décimation, le premier allocateur de valeurs (15) comportant un premier dispositif de correction (16),
- comporte un deuxième allocateur de valeurs (20) qui est couplé avec le circuit à boucle à verrouillage de phase (PLL) de signal pilote (10) et produit un deuxième signal de porteuse (×1.2) dont la fréquence est le double de celle du signal de porteuse (x2.1) ayant subi une décimation, le deuxième allocateur de valeurs (20) comportant un deuxième dispositif de correction (23), et
- comporte en outre un dispositif de commande (60) qui fournit, en correspondance avec le standard du signal MPX (mxp1), une valeur initiale (i0) et une première et/ou une deuxième valeurs de correction (k1, k2), la valeur initiale (i0) réglant le domaine de recherche du circuit à boucle à verrouillage de phase (PLL) de signal pilote (10) pour le signal pilote (p2) ayant subi une décimation et la première et/ou la deuxième valeurs de correction (k1, k2) corrigeant, dans le premier et/ou le deuxième dispositifs de correction (16, 23), la déviation de phase créée par le système du premier signal de porteuse (x2.1) ayant subi une décimation et/ou du deuxième signal de porteuse (x1.2).

3. Dispositif de génération de porteuse selon l'une des revendications 1 ou 2, **caractérisé en ce qu'**un troisième allocateur de valeurs (30) est couplé avec le circuit à boucle à verrouillage de phase (PLL) de signal pilote (10) et produit un troisième signal de porteuse (x1.3) dont la fréquence est soit réglée de manière fixe au moyen d'un multiplicateur de fréquences (32) à un rapport de fréquences prédéterminé, en particulier un nombre entier, par rapport à la fréquence du signal pilote (p1), soit peut être réglée de manière arbitraire au moyen d'une valeur de multiplication de fréquences (r) fournie par le dispositif de commande (60).

4. Dispositif de génération de porteuse selon la revendication 3, **caractérisé en ce qu'**un troisième dispositif de correction (33) corrige, dans le troisième allocateur de valeurs (30), la déviation de phase créée par le système du troisième signal de porteuse (x1.3) et/ou règle une position de phase définie, ce pour quoi une troisième valeur de correction (k3) est fournie au troisième dispositif de correction (33) par le dispositif de commande (60).

5. Dispositif de génération de porteuse selon l'une quelconque des revendications 1 à 4, **caractérisé en ce que** les premier, deuxième et/ou troisième dispositifs de correction (16, 23, 33) contiennent, pour la correction respective de la valeur de la phase (ϕ), un additionneur ou un soustracteur effectuant des calculs en modulo.

6. Dispositif de génération de porteuse selon l'une quelconque des revendications 1 à 5, **caractérisé en ce que**, pour la production d'une valeur d'incrément (ik) pour un oscillateur commandé en numérique (14), on envoie la valeur initiale (i0) à un régulateur (13) se trouvant dans le circuit à boucle à verrouillage de phase (PLL) de signal pilote (10) et que cette valeur soit sert de valeur initiale (i0.1) pour un accumulateur (13.4), soit y est additionnée ou soustraite en tant que valeur permanente (i0.2) à une valeur de sortie du régulateur (ik*), en constituant ainsi la valeur de l'incrément (ik).

7. Dispositif de génération de porteuse selon l'une quelconque des revendications 1 à 6, **caractérisé par** les caractéristiques suivantes :
- le dispositif de génération de porteuse comprend un détecteur de signal pilote (70) qui comporte :
- un multiplicateur (75) dont la première entrée reçoit le signal MPX (mxp1, mpx2) et dont la deuxième entrée reçoit un signal de porteuse (xq) qui a tourné de +/- 90 degrés par rapport au premier signal de porteuse (x1.1 ; x2.1) et qui est formé au moyen d'un autre premier allocateur de valeurs (15.1), qui est semblable au premier allocateur de valeurs (15) et d'une première valeur de correction modifiée (k1q),
- un filtre passe-bas (76) qui est raccordé à la sortie du multiplicateur (75) et
- un dispositif d'évaluation (77) qui est branché en aval du filtre passe-bas (76) et sur la sortie duquel on peut saisir un signal détecteur pilote (pd).
